# EUROPÄISCHE PATENTANMELDUNG

(11) **EP 3 782 764 A1**
(43) Veröffentlichungstag der Anmeldung: **24.02.2021**
(21) Anmeldenummer: 19192305.1
(22) Anmeldetag: 19.08.2019
(51) Int. Cl.: B23K 35/02, B23K 35/26, B23K 35/30, B23K 35/362, H01L 23/00

(54) **CU-PASTEN/LOTKOMBINATION ZUR ERZEUGUNG BLEIFREIER HOCHTEMEPRATURSTABILER LÖTVERBINDUNGEN**

(71) Anmelder: Heraeus Deutschland GmbH & Co KG, 63450 Hanau (DE)
(72) Erfinder: Schmitt, Wolfgang, 63450 Hanau (DE); Schäfer, Michael, 63450 Hanau (DE)
(74) Vertreter: Heraeus IP

(57) **Zusammenfassung**

Verfahren zum stoffschlüssigen Verbinden von Bauelementen, bei dem man
(a) ein Bauelement 1 und ein Bauelement 2 bereitstellt,
(b1) auf eine der zu verbindenden Oberflächen eine Schicht aus Kupferpaste appliziert, anschließend darauf ein Lotmittel appliziert und die Bauelemente 1 und 2 so anordnet, dass sie über die Kombination aus Kupferpaste und Lotmittel in Kontakt stehen, oder
(b2) auf eine der zu verbindenden Oberflächen ein Lotmittel oder eine Zinn(legierungs)schicht appliziert, anschließend darauf eine Schicht aus Kupferpaste appliziert und die Bauelemente 1 und 2 so anordnet, dass sie über die Kombination aus Lotmittel und Kupferpaste oder aus der Zinn(legierungs)schicht und Kupferpaste in Kontakt stehen, oder
(b3) auf eine der zu verbindenden Oberflächen eine Schicht aus Kupferpaste und auf die andere der zu verbindenden Oberflächen ein Lotmittel oder eine Zinn(legierungs)schicht appliziert und die Bauelemente 1 und 2 so anordnet, dass sie über die Schicht aus Kupferpaste und das Lotmittel oder über die Schicht aus Kupferpaste und die Zinn(legierungs)schicht in Kontakt stehen, oder
(b4) auf eine der zu verbindenden Oberflächen eine Schicht aus Kupferpaste appliziert und die Bauelemente 1 und 2 so anordnet, dass ihre zu verbindenden Oberflächen über die Schicht aus Kupferpaste in Kontakt stehen, und ein Lotmittel neben die oder auf einen von einem der Bauelemente 1 oder 2 nicht verdeckten Anteil der Schicht aus Kupferpaste appliziert, und
(c) die in Schritt (b1), (b2), (b3) oder (b4) geschaffene Anordnung verlötet,
wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

## Beschreibung

Die vorliegende Erfindung betrifft ein Verfahren zum stoffschlüssigen Verbinden von Bauelementen durch Löten.

WO2016/030287 offenbart ein Verfahren zum stoffschlüssigen Verbinden eines elektronischen Bauteils mit einem Substrat, bei dem man
a) ein elektronisches Bauteil mit einer ersten zu verbindenden Oberfläche und ein Substrat mit einer zweiten zu verbindenden Oberfläche bereitstellt,
b) auf wenigstens eine der zu verbindenden Oberflächen eine Kupferpaste appliziert und die Schicht aus Kupferpaste trocknet,
c1) ein Lotmittel auf die getrocknete Schicht aus Kupferpaste appliziert und das elektronische Bauteil und das Substrat so anordnet, dass die erste zu verbindende Oberfläche des elektronischen Bauteils mit der zweiten zu verbindenden Oberfläche des Substrats über die Zweischichtenkombination aus getrockneter Kupferpaste und Lotmittel in Kontakt steht,
   oder
c2) das elektronische Bauteil und das Substrat so anordnet, dass die erste zu verbindende Oberfläche des elektronischen Bauteils mit der zweiten zu verbindenden Oberfläche des Substrats über die getrocknete Kupferpaste in Kontakt steht und ein Lotmittel neben die Schicht aus getrockneter Kupferpaste appliziert und,
d) die in Schritt c1) oder c2) geschaffene Anordnung verlötet, um eine stoffschlüssige Verbindung zwischen dem elektronischen Bauteil und dem Substrat zu erzeugen,
   wobei die Kupferpaste (i) 66 - 99 Gew.-% (Gewichts-%) mindestens einer Art von jeweils einen Phosphoranteil von 0 bis ≤ 500 Gewichts-ppm aufweisenden Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 1 - 20 Gew.-% Vehikel enthält, wobei der mittlere Teilchendurchmesser der metallischen Partikel (i) und (ii) ≤ 15 µm beträgt.

WO2016/030287 A1 führt dazu aus, dass ein mittlerer Teilchendurchmesser von ≤ 15 µm beispielsweise bedeuten kann, dass wenigstens 90 Prozent der Partikel einen Teilchendurchmesser von ≤ 15 µm und weniger als 10 Prozent der Partikel einen Teilchendurchmesser von mehr als 15 µm aufweisen.

Während der Weiterentwicklung der aus WO2016/030287 A1 bekannten Technologie hat die Anmelderin die überraschende Feststellung gemacht, dass ein Wechsel zu einer Kupferpaste mit gröberen Kupferpartikeln bzw. mit Kupferpartikeln mit gröberer Partikelgrößenverteilung vorteilhaft ist, nicht nur mit Blick auf die Erzielung von den Anforderungen entsprechenden hohen Festigkeiten von Lötverbindungen zwischen Bauelementen, sondern auch im Hinblick auf eine gute elektrische Leitfähigkeit und Wärmeableitung der Lötverbindungen.

Die vorliegende Erfindung betrifft daher ein Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b1) auf eine der zu verbindenden Oberflächen eine Schicht aus Kupferpaste appliziert, anschließend darauf ein Lotmittel appliziert und die Bauelemente 1 und 2 so anordnet, dass ihre zu verbindenden Oberflächen über die Kombination aus Kupferpaste und Lotmittel in Kontakt stehen, oder
(b2) auf eine der zu verbindenden Oberflächen ein Lotmittel oder eine 10 bis 500 µm dicke Zinn(legierungs)schicht appliziert, anschließend darauf eine Schicht aus Kupferpaste appliziert und die Bauelemente 1 und 2 so anordnet, dass ihre zu verbindenden Oberflächen über die Kombination aus Lotmittel und Kupferpaste oder aus der Zinn(legierungs)schicht und Kupferpaste in Kontakt stehen, oder
(b3) auf eine der zu verbindenden Oberflächen eine Schicht aus Kupferpaste und auf die andere der zu verbindenden Oberflächen ein Lotmittel oder eine 10 bis 500 µm dicke Zinn(legierungs)schicht appliziert und die Bauelemente 1 und 2 so anordnet, dass ihre zu verbindenden Oberflächen über die Schicht aus Kupferpaste und das Lotmittel oder über die Schicht aus Kupferpaste und die Zinn(legierungs)schicht in Kontakt stehen, oder
(b4) auf eine der zu verbindenden Oberflächen eine Schicht aus Kupferpaste appliziert und die Bauelemente 1 und 2 so anordnet, dass ihre zu verbindenden Oberflächen über die Schicht aus Kupferpaste in Kontakt stehen, und ein Lotmittel neben die oder auf einen von einem der Bauelemente 1 oder 2 nicht verdeckten Anteil der Schicht aus Kupferpaste appliziert, und
(c) die in Schritt (b1), (b2), (b3) oder (b4) geschaffene Anordnung verlötet,
   wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

In einer ersten Ausführungsform handelt es sich demnach um ein Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b1) auf eine der zu verbindenden Oberflächen eine Schicht aus Kupferpaste appliziert, anschließend darauf ein Lotmittel appliziert und die Bauelemente 1 und 2 so anordnet, dass ihre zu verbindenden Oberflächen über die Kombination aus Kupferpaste und Lotmittel in Kontakt stehen, und
(c) die in Schritt (b1) geschaffene Anordnung verlötet,
   wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

In einer zweiten Ausführungsform handelt es sich demnach um ein Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b2) auf eine der zu verbindenden Oberflächen ein Lotmittel oder eine 10 bis 500 µm dicke Zinn(legierungs)schicht appliziert, anschließend darauf eine Schicht aus Kupferpaste appliziert und die Bauelemente 1 und 2 so anordnet, dass ihre zu verbindenden Oberflächen über die Kombination aus Lotmittel und Kupferpaste oder aus der Zinn(legierungs)schicht und Kupferpaste in Kontakt stehen, und
(c) die in Schritt (b2) geschaffene Anordnung verlötet,
   wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

In einer dritten Ausführungsform handelt es sich demnach um ein Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b3) auf eine der zu verbindenden Oberflächen eine Schicht aus Kupferpaste und auf die andere der zu verbindenden Oberflächen ein Lotmittel oder eine 10 bis 500 µm dicke Zinn(legierungs)schicht appliziert und die Bauelemente 1 und 2 so anordnet, dass ihre zu verbindenden Oberflächen über die Schicht aus Kupferpaste und das Lotmittel oder über die Schicht aus Kupferpaste und die Zinn(legierungs)schicht in Kontakt stehen, und
(c) die in Schritt (b3) geschaffene Anordnung verlötet,
   wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

In einer vierten Ausführungsform handelt es sich demnach um ein Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b4) auf eine der zu verbindenden Oberflächen eine Schicht aus Kupferpaste appliziert und die Bauelemente 1 und 2 so anordnet, dass ihre zu verbindenden Oberflächen über die Schicht aus Kupferpaste in Kontakt stehen, und ein Lotmittel neben die oder auf einen von einem der Bauelemente 1 oder 2 nicht verdeckten Anteil der Schicht aus Kupferpaste appliziert, und
(c) die in Schritt (b4) geschaffene Anordnung verlötet,
   wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

Alle vier Ausführungsformen des erfindungsgemäßen Verfahrens umfassen den gleichen Schritt (a), in welchem ein Bauelement 1 mit einer ersten zu verbindenden Oberfläche und ein Bauelement 2 mit einer zweiten zu verbindenden Oberfläche bereitgestellt werden.

Der hierin verwendete Begriff "Bauelement" bezeichnet insbesondere Bauteile, die in der Elektronik verwendet werden, kurz gesagt, elektronische Bauelemente. Beispiele dafür umfassen Dioden, LEDs (light emitting diodes, lichtemittierende Dioden), Dies, IGBTs (insulated-gate bipolar transistors, Bipolartransistoren mit isolierter Gate-Elektrode), MOSFETs (Metall-Oxid-Halbleiter-Feldeffekttransistoren), ICs (integrated circuits, integrierte Schaltungen), Sensoren, Kühlkörper, Widerstände, Kondensatoren, Spulen, Verbindungselemente (z. B. Clips), Bodenplatten, Antennen, Leadframes, PCBs (printed circuit boards, gedruckte Leiterplatten), flexible Elektronik, Keramiksubstrate, Metallkeramiksubstrate wie beispielsweise DCB-Substrate (direct copper bonded-Substrate), IMS (isoliertes Metallsubstrat) und dergleichen.

Die Bauelemente 1 und 2 können gleichartige oder verschiedenartige Bauelemente sein.

Die Bauelemente 1 und 2 können aus Metall bestehen oder ihre zu verbindenden Oberflächen können als Metallkontaktfläche, beispielsweise in Form einer Metallisierungsschicht, ausgebildet sein.

Bei den zu verbindenden Oberflächen der beiden Bauelemente 1 und 2 handelt es sich um Kontaktflächen. Die Größe der einzelnen Kontaktflächen der beiden Bauelemente 1 und 2 liegt im Allgemeinen im Bereich von beispielsweise 1 bis 100000 mm². Insbesondere kann die Größe der einzelnen Kontaktflächen der beiden Bauelemente 1 und 2 im Bereich von beispielsweise 1 bis 12000 mm² liegen, speziell bei im Allgemeinen rechteckiger Form mit Seitenlängen im Bereich von 1 mm mal 1 mm bis 200 mm mal 60 mm.

Die zu verbindenden Oberflächen der beiden Bauelemente 1 und 2 bilden eine gemeinsame Überlappungsfläche miteinander. Im Allgemeinen wird dabei die Kontaktfläche des Bauelements mit der kleineren Kontaktfläche vollständig ausgenutzt, d.h. im Allgemeinen entspricht die Größe der Überlappungsfläche der der vollständigen Kontaktfläche des Bauelements mit der kleineren Kontaktfläche.

Weder die Kupferpaste noch das Lotmittel enthalten Blei und sind damit bleifrei. Erfindungsgemäß ist unter bleifrei zu verstehen, dass Kupferpaste und Lotmittel abgesehen von gegebenenfalls vorhandenen, technisch bedingten Blei-Verunreinigungen kein Blei enthalten. Unter bleifrei wird demnach ein Bleigehalt von ≤ 0,1 Gew.-%, noch mehr bevorzugt ≤ 0,01 Gew.-% und insbesondere 0 Gew.-% auf Basis des Gewichts der Kupferpaste bzw. des Lotmittels verstanden.

Bei der ersten Ausführungsform des erfindungsgemäßen Verfahrens wird in Schritt (b1) eine Schicht aus Kupferpaste auf eine der zu verbindenden Oberflächen appliziert, anschließend auf die Schicht aus Kupferpaste ein Lotmittel appliziert und die Bauelemente 1 und 2 werden dann so angeordnet, dass ihre zu verbindenden Oberflächen über die Kombination aus Kupferpaste und Lotmittel in Kontakt stehen.

Bezogen auf ihr Gewicht enthält die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-%, bevorzugt 5-15 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

In einer Ausführungsform umfasst die Kupferpaste neben diesen Bestandteilen (i), (ii) und (iii) respektive (i) und (iii) keine weiteren Bestandteile.

Die Reinheit des Kupfers der in der Kupferpaste enthaltenen Kupferpartikel (i) beträgt wenigstens 99,5 Gew.-%. Im Falle der Partikel (i) aus kupferreichen Kupfer/Zink-Legierungen bzw. kupferreichen Kupfer/Zinn-Legierungen beträgt die Zusammensetzung beispielsweise 60 bis 99,5 Gew.-% Kupfer und entsprechend 0,5 bis 40 Gew.-% Zink bzw. Zinn. Der Phosphoranteil der Partikel (i) kann bis zu 0,4 Gewichts-% betragen. Es kann sich bei den Partikeln (i) um durch Schmelzverdüsung unter Luft- oder Inertgasatmosphäre hergestellte Partikel oder, mit anderen Worten, um durch Verdüsung von flüssigem (geschmolzenem) Kupfer bzw. einer Schmelze einer der besagten Kupferlegierungen in Luft oder in eine Inertgasatmosphäre hinein hergestellte Partikel. Die Partikel (i) können herstellungsbedingt sphärisch oder nichtsphärisch sein; sie weisen ein Aspektverhältnis beispielsweise im Bereich von 1 : 1 (ideale Kugelform) bis 3 : 1 auf. Das Aspektverhältnis kann mikroskopisch durch Bestimmung der Abmessungen einer statistisch bedeutsamen Anzahl von einzelnen Partikeln bestimmt werden. Der Anteil an Partikeln (i) in Gestalt von Flakes (Plättchen) unterschreitet 5 %, liegt bevorzugt bei < 1 % und insbesondere bevorzugt sind keine Flakes umfasst.

Die Partikel (i) weisen eine mittlere Partikelgröße - auch als mittlerer Teilchendurchmesser bezeichnet - im Bereich von 20 bis 50 µm auf.

Die mittlere Partikelgröße kann mittels Laserbeugung bestimmt werden. Laserbeugungsmessungen können mit einem entsprechenden Partikelgrößenmessgerät, beispielsweise einem Mastersizer 3000 von Malvern Instruments durchgeführt werden. Eine konkrete mittlere Partikelgröße mit einem Wert X µm im Bereich von 20 bis 50 µm kann beispielsweise bedeuten, dass wenigstens 90 Prozent der Partikel eine Partikelgröße von ≤ X µm und weniger als 10 Prozent der Partikel eine Partikelgröße von mehr als X µm aufweisen.

Die absoluten Partikelgrößen der Partikel (i) liegen zumindest im Wesentlichen innerhalb des Bereichs von ≥ 4 µm bis ≤ 70 µm. "Zumindest im Wesentlichen" bedeutet hier, dass ungünstigstenfalls ein unwesentlicher, d.h. vernachlässigbarer Anteil außerhalb des Bereichs von ≥ 4 µm bis ≤ 70 µm liegt, beispielsweise liegt höchstens 1 von 100 Partikeln (i) oberhalb von 70 µm, beispielsweise im Bereich von >70 bis 100 µm. Ebenso liegen beispielsweise höchstens 1 von 100 Partikeln (i) unterhalb von 4 µm, beispielsweise im Bereich von 0,5 bis < 4 µm. Bevorzugt liegt kein Partikel oberhalb von 70 µm respektive unterhalb von 4 µm. Die absolute Partikelgröße kann mikroskopisch durch Bestimmung der Abmessungen einer statistisch bedeutsamen Anzahl von einzelnen Partikeln (i) bestimmt werden.

In einer Ausführungsform kann die Kupferpaste mindestens eine Art von Lotmetallpartikeln (ii) ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe enthalten. Sind in der Kupferpaste Lotmetallpartikel aus zinnreichen Zinn/Kupfer-, Zinn/Silber- bzw. Zinn/Kupfer/Silber-Legierungen enthalten, so liegt deren Zinnanteil vorzugsweise im Bereich von 95 - 99,5 Gew.-%, während der Anteil von Kupfer und/oder Silber dementsprechend im Bereich von 0,5 - 5 Gew.-% liegt.

Die Lotmetallpartikel (ii) können sphärisch oder nichtsphärisch sein; sie weisen ein Aspektverhältnis beispielsweise im Bereich von 1 : 1 bis 3 : 1 auf. Das Aspektverhältnis kann mikroskopisch durch Bestimmung der Abmessungen einer statistisch bedeutsamen Anzahl von einzelnen Partikeln bestimmt werden. Der Anteil an Lotmetallpartikeln (ii) in Gestalt von Flakes unterschreitet 5 %, liegt bevorzugt bei < 1 % und insbesondere bevorzugt sind keine Flakes umfasst. Die Partikelgröße der Lotmetallpartikel (ii) kann der der Partikel (i) ähneln oder entsprechen.

Neben den Metallpartikeln vom Typ (i) und gegebenenfalls (ii) umfasst die Kupferpaste ein sogenanntes Vehikel (iii), welches Verdicker und organisches Lösemittel umfasst oder daraus besteht. Beispiele für Verdicker umfassen gegebenenfalls modifizierte natürliche Verdicker wie Gelatine, Stärke, Pektin, Celluloseether, Ester natürlicher organischer Öle. Beispiele für organische Lösemittel umfassen Glykol, Glycerin, Terpineol, aliphatische Kohlenwasserstoffe. Der Verdickeranteil des Vehikels liegt beispielsweise bei 0,5 - 15 Gew.-%, vorzugsweise bei 2 - 10 Gew.-% und mehr bevorzugt bei 4 - 7 Gew.-%, während der Anteil organischen Lösemittels bei 85 - 99,5 Gew.-%, vorzugsweise bei 90 - 98 Gew.-% und mehr bevorzugt bei 93 - 96 Gew.-% liegt.

Die Applikation der Kupferpaste auf eine der zu verbindenden Oberflächen kann durch eines der aus dem Stand der Technik bekannten Verfahren, beispielsweise Siebdruckverfahren, Schablonendruckverfahren, Jet- oder Dispenstechnik, erfolgen. Die Kupferpaste wird beispielsweise in einer Schichtdicke von 20 - 200 µm appliziert und kann dann gegebenenfalls zunächst getrocknet werden, beispielsweise bei einer Objekttemperatur von 50 - 160°C.

Anschließend wird ein Lotmittel auf die gegebenenfalls getrocknete Schicht aus Kupferpaste appliziert.

Bei dem Lotmittel kann es sich um eine Lotpaste oder um ein oder mehrere Formteile aus Lotmetall handeln.

Beim Lotmittel in Form einer Lotpaste kann letztere, bezogen auf ihr Gewicht, 80 - 99 Gew.-%, vorzugsweise 85 - 95 Gew.-% und mehr bevorzugt 87 - 92 Gew.-% mindestens einer Art von Lotmetallpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und 1 - 20 Gew.-%, vorzugsweise 5 - 15 Gew.-% und mehr bevorzugt 8 - 13 Gew.-% Flussmittel oder Vehikel enthalten. Bevorzugt besteht die Lotpaste, bezogen auf ihr Gewicht, aus 80 - 99 Gew.-%, vorzugsweise 85 - 95 Gew.-% und mehr bevorzugt 87 - 92 Gew.-% mindestens einer Art von Lotmetallpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe, und 1 - 20 Gew.-%, vorzugsweise 5 - 15 Gew.-% und mehr bevorzugt 8 - 13 Gew.-% Flussmittel oder Vehikel.

Sind in der Lotpaste Lotmetallpartikel aus zinnreichen Zinn/Kupfer-, Zinn/Silber- bzw. Zinn/Kupfer/Silber-Legierungen enthalten, so liegt deren Zinnanteil beispielsweise im Bereich von 95 - 99,5 Gew.-%, während der Anteil von Kupfer und/oder Silber dementsprechend im Bereich von 0,5 - 5 Gew.-% liegt.

Falls die Lotpaste Flussmittel enthält, so ist es dessen Aufgabe, die Oberfläche des Substrats und/oder des elektronischen Bauteils beim Löten zu reduzieren (d.h. zu entoxidieren), die erneute Oxidbildung vor und während des Lötvorgangs zu verhindern und Einschlüsse von Fremdstoffen zu verringern. Ferner soll durch den Zusatz des Flussmittels die Oberflächenspannung des flüssigen Lotes verringert werden. Als Flussmittel können beispielsweise Kolophonium, auf Kolophonium basierende Harzsysteme, auf Wasser basierende Harzsysteme oder Systeme auf der Basis von Carbonsäuren (z.B. Carbonsäuren wie Zitronensäure, Adipinsäure, Zimtsäure und Benzylsäure), Aminen (z.B. tertiäre Amine) und Lösemitteln (z.B. polare Lösemittel, enthaltend Wasser und ein Polyol, wie Glykol oder Glycerin) verwendet werden.

Daneben können in der Lotpaste weitere Bestandteile, wie zum Beispiel Alkohole, Fettsäuren (z.B. gesättigte Fettsäuren, wie Ölsäure, Myristinsäure, Palmitinsäure, Margarinsäure, Stearinsäure oder Arachinsäure), Polysiloxan-Verbindungen oder Phosphid-Verbindungen, enthalten sein.

Wie schon gesagt, kann die Lotpaste anstelle von Flussmittel sogenanntes Vehikel enthalten. Um unnötige Wiederholungen zu vermeiden, wird auf die vorstehend im Zusammenhang mit der Beschreibung der Kupferpaste zum Vehikel gemachten Ausführungen verwiesen.

Die Applikation der Lotpaste auf die gegebenenfalls getrocknete Schicht aus Kupferpaste kann durch eines der aus dem Stand der Technik bekannten Verfahren, beispielsweise Siebdruckverfahren, Schablonendruckverfahren oder Jet- oder Dispenstechnik, erfolgen. Die Lotpaste wird beispielsweise in einer Nassschichtdicke von 20 - 200 µm appliziert und kann dann gegebenenfalls getrocknet werden, beispielsweise für 10 - 60 Minuten bei einer Objekttemperatur von 50 - 160 °C. Bei der Applikation und der sich gegebenenfalls anschließenden Trocknung der Lotpaste wird das darin enthaltene Lotmetall nicht geschmolzen.

Beim Lotmittel in Form mindestens eines Formteils aus Lotmetall handelt es sich beispielsweise um Kügelchen, Folie, Draht oder Zylinder. Die Formteile werden ausgewählt aus der aus Zinn-Formteilen, zinnreichen Zinn/Kupfer-Legierungsformteilen, zinnreichen Zinn/Silber-Legierungsformteilen und zinnreichen Zinn/Kupfer/Silber-Legierungsformteilen bestehenden Gruppe. Im Falle der zinnreichen Zinn/Kupfer-, Zinn/Silber- bzw. Zinn/Kupfer/SilberLegierungen liegt deren Zinnanteil beispielsweise im Bereich von 95 - 99,5 Gew.-%, während der Anteil von Kupfer und/oder Silber dementsprechend im Bereich von 0,5 - 5 Gew.-% liegt.

Die Applikation des mindestens einen Lotmetallformteils besteht üblicherweise in einem simplen Platzieren auf der gegebenenfalls getrockneten Schicht aus Kupferpaste. Hier kann es zweckmäßig sein, beim anschließenden Anordnen der beiden Bauelemente 1 und 2 ein Fixiermittel, beispielsweise in Form einer Klebstoffzusammensetzung, zwischen dem mindestens einen Lotmetallformteil und der anderen zu verbindenden Oberfläche zu applizieren. Bei der Applikation des mindestens einen Lotmetallformteils wird das Lotmetall nicht geschmolzen.

Nach Applikation des Lotmittels auf die gegebenenfalls getrocknete Schicht aus Kupferpaste werden die Bauelemente 1 und 2 so angeordnet, dass ihre zu verbindenden Oberflächen über die Kombination aus gegebenenfalls getrockneter Kupferpaste und Lotmittel in Kontakt stehen und Schritt (b1) des erfindungsgemäßen Verfahrens ist damit abgeschlossen.

Bei der zweiten Ausführungsform des erfindungsgemäßen Verfahrens wird in Schritt (b2) ein Lotmittel oder eine 10 bis 500 µm dicke Zinn(legierungs)schicht auf eine der zu verbindenden Oberflächen appliziert, anschließend darauf eine Schicht aus Kupferpaste appliziert und die Bauelemente 1 und 2 werden dann so angeordnet, dass ihre zu verbindenden Oberflächen über die Kombination aus Lotmittel und Kupferpaste oder aus Zinn(legierungs)schicht und Kupferpaste in Kontakt stehen.

Der hierin verwendete Begriff "Zinn(legierung)" bedeutet Zinn oder Zinnlegierung (eine auf Zinn basierende Legierung mit einem Zinnanteil von ≥80 Gew.-%).

Bezüglich des Lotmittels in Form von Lotpaste oder in Form mindestens eines Formteils aus Lotmetall und der Kupferpaste wird auf das bei der detaillierten Beschreibung der ersten Ausführungsform des erfindungsgemäßen Verfahrens Vorerwähnte verwiesen.

Die als Alternative zum Lotmittel genannte 10 bis 500 µm dicke Zinn(legierungs)schicht kann mittels dem Fachmann bekannten Methoden auf die eine der zu verbindenden Oberflächen appliziert werden, beispielsweise galvanisch oder durch Applikation und Aufschmelzen eines Lotmittels, beispielsweise in Form von Lotpaste oder in Form mindestens eines Lotmetallformteils.

Die Applikation eines Lotmittels in Form von Lotpaste anstelle der 10 bis 500 µm dicken Zinn(legierungs)schicht auf die eine der zu verbindenden Oberflächen kann durch eines der aus dem Stand der Technik bekannten Verfahren, beispielsweise Siebdruckverfahren, Schablonendruckverfahren oder Jet- oder Dispenstechnik, erfolgen. Die Lotpaste wird beispielsweise in einer Nassschichtdicke von 20 - 200 µm appliziert und kann dann gegebenenfalls getrocknet werden, beispielsweise für 10 - 60 Minuten bei einer Objekttemperatur von 50 - 160 °C. Bei der Applikation und der sich gegebenenfalls anschließenden Trocknung der Lotpaste wird das darin enthaltene Lotmetall nicht geschmolzen.

Die Applikation eines Lotmittels in Form mindestens eines Formteils aus Lotmetall anstelle der 10 bis 500 µm dicken Zinn(legierungs)schicht besteht üblicherweise in einem simplen Platzieren auf die eine der zu verbindenden Oberflächen. Dabei kann es zweckmäßig sein, ein Fixiermittel, beispielsweise in Form einer Klebstoffzusammensetzung, zwischen dem mindestens einen Lotmetallformteil und der einen zu verbindenden Oberfläche zu applizieren. Bei der Applikation des mindestens einen Lotmetallformteils wird das Lotmetall nicht geschmolzen.

Anschließend wird eine Schicht aus Kupferpaste auf das applizierte Lotmittel oder auf die Zinn(legierungs)schicht appliziert.

Die Applikation der Kupferpaste kann durch eines der aus dem Stand der Technik bekannten Verfahren, beispielsweise Siebdruckverfahren, Schablonendruckverfahren, Jet- oder Dispenstechnik, erfolgen. Die Kupferpaste wird beispielsweise in einer Schichtdicke von 20 - 200 µm appliziert und kann dann gegebenenfalls zunächst getrocknet werden, beispielsweise für 10 - 60 Minuten bei einer Objekttemperatur von 50 - 160° C.

Nach Applikation der Schicht aus Kupferpaste werden die Bauelemente 1 und 2 so angeordnet, dass ihre zu verbindenden Oberflächen über die Kombination aus Lotmittel und gegebenenfalls getrockneter Kupferpaste oder aus Zinn(legierungs)schicht und gegebenenfalls getrockneter Kupferpaste in Kontakt stehen und Schritt (b2) des erfindungsgemäßen Verfahrens ist damit abgeschlossen.

Bei der dritten Ausführungsform des erfindungsgemäßen Verfahrens wird in Schritt (b3) eine Schicht aus Kupferpaste auf eine der zu verbindenden Oberflächen, und ein Lotmittel oder eine 10 bis 500 µm dicke Zinn(legierungs)schicht auf die andere der zu verbindenden Oberflächen appliziert und die Bauelemente 1 und 2 werden so angeordnet, dass ihre zu verbindenden Oberflächen über die Schicht aus Kupferpaste und das Lotmittel oder über die Schicht aus Kupferpaste und die 10 bis 500 µm dicke Zinn(legierungs)schicht in Kontakt stehen.

Bezüglich des Lotmittels in Form von Lotpaste oder in Form mindestens eines Formteils aus Lotmetall und der Kupferpaste wird auf das bei der detaillierten Beschreibung der ersten Ausführungsform des erfindungsgemäßen Verfahrens Vorerwähnte verwiesen.

Die Applikation der Kupferpaste auf die eine der zu verbindenden Oberflächen kann durch eines der aus dem Stand der Technik bekannten Verfahren, beispielsweise Siebdruckverfahren, Schablonendruckverfahren, Jet- oder Dispenstechnik, erfolgen. Die Kupferpaste wird beispielsweise in einer Schichtdicke von 20 - 200 µm appliziert und kann dann gegebenenfalls zunächst getrocknet werden, beispielsweise für 10 - 60 Minuten bei einer Objekttemperatur von 50 - 160° C.

Die als Alternative zum Lotmittel genannte 10 bis 500 µm dicke Zinn(legierungs)schicht kann mittels dem Fachmann bekannten Methoden auf die andere der zu verbindenden Oberflächen appliziert werden, beispielsweise galvanisch oder durch Applikation und Aufschmelzen eines Lotmittels, beispielsweise in Form von Lotpaste oder in Form mindestens eines Lotmetallformteils.

Die Applikation eines Lotmittels in Form von Lotpaste anstelle der 10 bis 500 µm dicken Zinn(legierungs)schicht auf die andere der zu verbindenden Oberflächen kann durch eines der aus dem Stand der Technik bekannten Verfahren, beispielsweise Siebdruckverfahren, Schablonendruckverfahren oder Jet- oder Dispenstechnik, erfolgen. Die Lotpaste wird beispielsweise in einer Nassschichtdicke von 20 - 200 µm appliziert und kann gegebenenfalls getrocknet werden, beispielsweise für 10 - 60 Minuten bei einer Objekttemperatur von 50 - 160 °C. Bei der Applikation und der sich gegebenenfalls anschließenden Trocknung der Lotpaste wird das darin enthaltene Lotmetall nicht geschmolzen.

Die Applikation eines Lotmittels in Form mindestens eines Formteils aus Lotmetall anstelle der 10 bis 500 µm dicken Zinn(legierungs)schicht auf die andere der zu verbindenden Oberflächen besteht üblicherweise in einem simplen Platzieren. Dabei kann es zweckmäßig sein ein Fixiermittel, beispielsweise in Form einer Klebstoffzusammensetzung, zwischen dem mindestens einen Lotmetallformteil und der anderen zu verbindenden Oberfläche zu applizieren. Bei der Applikation des mindestens einen Lotmetallformteils wird das Lotmetall nicht geschmolzen.

Nach der Applikation der Schicht aus Kupferpaste auf die eine zu verbindende Oberfläche und Applikation der Zinn(legierungs)schicht oder des Lotmittels auf die andere zu verbindende Oberfläche werden die Bauelemente 1 und 2 so angeordnet, dass ihre zu verbindenden Oberflächen über die Schicht aus gegebenenfalls getrockneter Kupferpaste und das Lotmittel oder über die Schicht aus gegebenenfalls getrockneter Kupferpaste und die 10 bis 500 µm dicke Zinn(legierungs)schicht in Kontakt stehen und Schritt (b3) des erfindungsgemäßen Verfahrens ist damit abgeschlossen.

Bei der vierten Ausführungsform des erfindungsgemäßen Verfahrens wird in Schritt (b4) eine Schicht aus Kupferpaste auf eine der zu verbindenden Oberflächen appliziert, und die Bauelemente 1 und 2 werden so angeordnet, dass ihre zu verbindenden Oberflächen über die Schicht aus Kupferpaste in Kontakt stehen. Anschließend wird ein Lotmittel neben die oder auf einen von einem der Bauelemente 1 oder 2 nicht verdeckten Anteil der Schicht aus Kupferpaste appliziert.

Bezüglich des Lotmittels in Form von Lotpaste oder in Form mindestens eines Formteils aus Lotmetall und der Kupferpaste wird auf das bei der detaillierten Beschreibung der ersten Ausführungsform des erfindungsgemäßen Verfahrens Vorerwähnte verwiesen.

Die Applikation der Kupferpaste auf eine der zu verbindenden Oberflächen in Schritt (b4) kann durch eines der aus dem Stand der Technik bekannten Verfahren, beispielsweise Siebdruckverfahren, Schablonendruckverfahren, Jet- oder Dispenstechnik, erfolgen. Die Kupferpaste wird beispielsweise in einer Schichtdicke von 20 - 200 µm appliziert und kann dann gegebenenfalls zunächst getrocknet werden, beispielsweise für 10 - 60 Minuten bei einer Objekttemperatur von 50 - 160° C.

Nach Applikation der Schicht aus Kupferpaste werden die Bauelemente 1 und 2 so angeordnet, dass ihre zu verbindenden Oberflächen über die gegebenenfalls getrocknete Kupferpaste in Kontakt stehen.

Anschließend wird ein Lotmittel neben die oder auf einen von einem der Bauelemente 1 oder 2 nicht verdeckten Anteil der Schicht aus gegebenenfalls getrockneter Kupferpaste appliziert.

Die Applikation eines Lotmittels in Form von Lotpaste kann durch eines der aus dem Stand der Technik bekannten Verfahren, beispielsweise Siebdruckverfahren, Schablonendruckverfahren oder Jet- oder Dispenstechnik, erfolgen. Bei der Applikation neben die Schicht aus gegebenenfalls getrockneter Kupferpaste kann so gearbeitet werden, dass die Lotpaste die gegebenenfalls getrocknete Kupferpaste seitlich (von einer, mehreren oder allen Seiten her) berührt oder einen geringen Abstand von beispielsweise bis zu 2 mm dazu hat; beim späteren Löten in Schritt (c) verfließt die Lotpaste schließlich und infiltriert unterstützt durch den Kapillareffekt die spätestens während Schritt (c) getrocknete Kupferpastenmatrix. Auch bei der Applikation auf einen von einem der Bauelemente 1 oder 2 nicht verdeckten Anteil der Schicht der gegebenenfalls getrockneten Kupferpaste verfließt die Lotpaste beim späteren Löten in Schritt (c) und infiltriert unterstützt durch den Kapillareffekt die spätestens während Schritt (c) getrocknete Kupferpastenmatrix.

Die Lotpaste wird beispielsweise in einer Nassschichtdicke von 20 - 200 µm appliziert und gegebenenfalls getrocknet, beispielsweise für 10 - 60 Minuten bei einer Objekttemperatur von 50 - 160 °C. Bei der Applikation und der sich gegebenenfalls anschließenden Trocknung der Lotpaste wird das darin enthaltene Lotmetall nicht geschmolzen.

Die Applikation eines Lotmittels in Form mindestens eines Formteils aus Lotmetall besteht üblicherweise in einem simplen Platzieren. Bei der Applikation neben die Schicht aus gegebenenfalls getrockneter Kupferpaste kann so gearbeitet werden, dass das mindestens eine Lotmetallformteil die getrocknete Kupferpaste seitlich (von einer, mehreren oder allen Seiten her) berührt oder einen geringen Abstand von beispielsweise bis zu 2 mm dazu hat; beim späteren Löten in Schritt (c) schmilzt das mindestens eine Lotmetallformteil schließlich und infiltriert unterstützt durch den Kapillareffekt die spätestens während Schritt (c) getrocknete Kupferpastenmatrix. Auch bei der Applikation auf einen von einem der Bauelemente 1 oder 2 nicht verdeckten Anteil der Schicht der gegebenenfalls getrockneten Kupferpaste schmilzt das mindestens eine Lotmetallformteil beim späteren Löten in Schritt (c) und infiltriert unterstützt durch den Kapillareffekt die spätestens während Schritt (c) getrocknete Kupferpastenmatrix.

Nach Applikation des Lotmittels neben die zwischen den zu verbindenden Oberflächen der Bauelemente 1 und 2 befindliche gegebenenfalls getrocknete Schicht aus Kupferpaste oder auf einen von einem der Bauelemente 1 oder 2 nicht verdeckten Anteil der gegebenenfalls getrockneten Schicht aus Kupferpaste ist Schritt (b4) des erfindungsgemäßen Verfahrens abgeschlossen.

Die so nach Abschluss des Schrittes (b1), (b2), (b3) respektive (b4) geschaffene Anordnung der Bauelemente 1 und 2 wird in dem allen vier Ausführungsformen des erfindungsgemäßen Verfahrens eigenen Schritt (c) verlötet. Hierbei handelt es sich um ein sogenanntes Diffusionslöten.

Beim Verlöten wird gegebenenfalls nicht getrocknete Kupferpaste und, soweit Lotpaste als Lotmittel appliziert wurde, gegebenenfalls nicht getrocknete Lotpaste im Sinne einer Befreiung von flüchtigen Bestandteilen getrocknet; gegebenenfalls vorhandenes Fixiermittel wird ebenfalls entfernt, beispielsweise indem es unzersetzt verdampft und/oder sich unter Zersetzung verflüchtigt, sodass keine oder keine störenden Rückstände verbleiben. Beim Verlöten wird eine stoffschlüssige Verbindung zwischen den Bauelementen 1 und 2 erzeugt. Stoffschlüssige Verbindungen sind Verbindungen, bei denen die Verbindungspartner durch atomare oder molekulare Kräfte zusammengehalten werden. Sie stellen vorzugsweise nicht lösbare Verbindungen dar, die sich zerstörend trennen lassen.

Zum Löten wird die vorstehend beschriebene Anordnung vorzugsweise gleichmäßig bis zum Erreichen der eigentlichen Löttemperatur erhitzt. Gemäß einer Ausführungsform erfolgt das Erhitzen mit einer Geschwindigkeit von ≤ 3 °C pro Sekunde.

Die Löttemperatur liegt vorzugsweise etwa 10 - 50 °C, mehr bevorzugt etwa 15 - 45 °C und noch mehr bevorzugt etwa 25 - 35 °C, zum Beispiel etwa 30 °C über der Schmelztemperatur des im Lotmittel enthaltenen Lotmetalls oder der Zinn(legierung). Gemäß einer weiteren bevorzugten Ausführungsform liegt die Löttemperatur unterhalb von 280 °C, so zum Beispiel im Bereich von 240 - 260 °C.

Zum Löten wird die Temperatur für eine Zeit von wenigstens 15 Sekunden, vorzugsweise von wenigstens 20 Sekunden und noch mehr bevorzugt von wenigstens 30 Sekunden über der Liquidustemperatur des im Lotmittel enthaltenen Lotmetalls oder der Zinn(legierung). aufrechterhalten.

Während des Lötvorgangs infiltriert das geschmolzene Lotmetall die getrocknete Kupferpaste. Das erfindungsgemäße Verfahren gewährleistet eine ausgeprägte Infiltrationstiefe des geschmolzenen Lotmetalls von beispielsweise bis zu 30 mm in die getrocknete Kupferpaste. Es wird angenommen, dass dies eine positive Folge der 4 µm zumindest im Wesentlichen nicht unterschreitenden absoluten Partikelgrößen der Partikel (i) ist. Bei Verwendung einer Kupferpaste mit feineren Kupferpartikeln ist die Infiltration durch das Lotmetall wesentlich geringer ausgeprägt. Eine hohe Infiltrationstiefe geht einher mit einer guten elektrischen Leitfähigkeit und Wärmeableitung der betreffenden Lötverbindung.

### Beispiele

Es wurden Pasten mit der in Tabelle 1 angegebenen gewichtsprozentualen Zusammensetzung hergestellt. Bei dem Vehikel handelte es sich jeweils um eine Mischung aus 95 Gew.-% Terpineol und 5 Gew.-% Ethylcellulose.

**Tabelle 1**

| | Referenzbeispiel 1 | Vergleichsbeispiel 2 | Erfindungsgemäßes Beispiel 3 | Erfindungsgemäßes Beispiel 4 | Erfindungsgemäßes Beispiel 5 | Erfindungsgemäßes Beispiel 6 |
|---|---|---|---|---|---|---|
| | Lotpaste | Kupferpaste | Kupferpaste | Kupferpaste | Kupferpaste | Kupferpaste |
| Partikelart (mittlere Partikelgröße in µm): | | | | | | |
| Kupfer (35)^{*)} | | | 78 | | 78 | |
| Kupfer (16) | | 80 | | | | |
| CuSn10 (35)^{*)} | | | | 81 | | 80 |
| SnCu0,7 (25)^{*)} | | | | 9 | 10 | |
| SnAg3,0Cu0,5 (25) | 90 | 10 | 10 | | | 10 |
| Vehikel | 10 | 10 | 12 | 10 | 12 | 10 |

| | | | | | | |
|---|---|---|---|---|---|---|
| ^{*)} Absolute Partikelgröße innerhalb des Bereichs von ≥ 4 µm bis ≤ 70 µm. | | | | | | |

Die jeweilige Kupferpaste (Beispiele 2 bis 6) wurde mittels einer Metallschablone 80 µm dick auf ein Kupferblech aufgetragen. Anschließend wurde die mit der Kupferpaste versehene Oberfläche des Kupferblechs maschinell mit einem 5 mm mal 5 mm großen Nacktchip bestückt, der eine Metallisierungsschicht aus Nickel/Silber aufwies. Hierzu wurde der Nacktchip so auf die Kupferpaste gesetzt, dass die Metallisierungsschicht des Nacktchips mit dem Kupferblech über die Kupferpaste in Kontakt stand. Unmittelbar neben dieser Anordnung wurde ein Lotmetallformteil (Lotdraht aus SnAg3,0Cu0,5-Legierung mit 0,5 mm Durchmesser und 5 mm Länge) auf das Kupferblech platziert.

Nunmehr wurde diese Anordnung aus Kupferblech, Nacktchip, dazwischen angeordneter Kupferpaste und platziertem Lotmetallformteil in einen Kammer-Lötofen eingebracht, mit einer Rate von 0,5 Kelvin pro Sekunde auf eine Temperatur von 60 °C erhitzt und bei dieser Temperatur für 1 Stunde unter Inertgasatmosphäre getrocknet. Unmittelbar danach erfolgte eine Erhöhung der Temperatur auf 200 °C und eine Aktivierung/Reduktion der Reaktionsoberflächen mittels Ameisensäure-gesättigter Stickstoffatmosphäre. Danach erfolgte im gleichen Lötofen eine Erhöhung der Temperatur auf 260 °C und die Lötung dieser Anordnung unter Vakuum (1 mbar) in einer Lötzeit von 10 Minuten.

Zu Vergleichszwecken wurde eine vergleichbare Anordnung unter Verwendung einer Lotpaste (Beispiel 1) erstellt, jedoch ohne Platzierung eines Lotmetallformteils: Die Lotpaste wurde mittels einer Metallschablone 80 µm dick auf das Kupferblech appliziert und darauf wiederum der Nacktchip gesetzt. Die Trocknung und Lötung dieser Anordnung erfolgte wie vorbeschrieben bei gleichen Aktivierungsparametern und reduzierter Löttemperatur von 240 °C.

Die bei 260°C bestimmten Scherfestigkeiten der Lötverbindungen bzw. verlöteten Anordnungen findet man in Tabelle 2. Eine Scherfestigkeit bei 260°C von > 20N/mm² entspricht dem Sollwert.

**Tabelle 2**

| | Beispiel 1 | Beispiel 2 | Beispiel 3 | Beispiel 4 | Beispiel 5 | Beispiel 6 |
|---|---|---|---|---|---|---|
| Scherfestigkeit bei 260°C | 3,1 N/mm² | 18 N/mm² | 34 N/mm² | 38 N/mm² | 35 N/mm² | 30 N/mm² |

Im Falle der Beispiele 2 - 6 wurde desweiteren die Infiltrationstiefe des Lotes in die getrocknete Kupferpaste bestimmt. Dazu wurde die jeweilige Kupferpaste mittels einer Metallschablone mit einer Öffnung von 10 mm mal 40 mm 100 µm dick auf ein Kupferblech aufgetragen. Unmittelbar neben die 10 mm kurze Seite der applizierten Kupferpaste wurde ein Lotmetallformteil (Lotdraht aus SnAg3,0Cu0,5-Legierung mit 0,5 mm Durchmesser und 10 mm Länge) auf das Kupferblech platziert und die Anordnung einer Trocknung und Lötung analog wie vorerwähnt (ohne Nacktchip) unterzogen.

Die Infiltrationstiefen findet man in Tabelle 3.

**Tabelle 3**

| | Beispiel 2 | Beispiel 3 | Beispiel 4 | Beispiel 5 | Beispiel 6 |
|---|---|---|---|---|---|
| Infiltrationstiefe | 14 mm | 30 mm | 28 mm | 21 mm | 31 mm |

## Patentansprüche

1. Verfahren zum stoffschlüssigen Verbinden von Bauelementen, bei dem man
(a) ein Bauelement 1 mit einer ersten zu verbindenden Oberfläche und ein Bauelement 2 mit einer zweiten zu verbindenden Oberfläche bereitstellt,
(b1) auf eine der zu verbindenden Oberflächen eine Schicht aus Kupferpaste appliziert, anschließend darauf ein Lotmittel appliziert und die Bauelemente 1 und 2 so anordnet, dass ihre zu verbindenden Oberflächen über die Kombination aus Kupferpaste und Lotmittel in Kontakt stehen, oder
(b2) auf eine der zu verbindenden Oberflächen ein Lotmittel oder eine 10 bis 500 µm dicke Zinn(legierungs)schicht appliziert, anschließend darauf eine Schicht aus Kupferpaste appliziert und die Bauelemente 1 und 2 so anordnet, dass ihre zu verbindenden Oberflächen über die Kombination aus Lotmittel und Kupferpaste oder aus der Zinn(legierungs)schicht und Kupferpaste in Kontakt stehen, oder
(b3) auf eine der zu verbindenden Oberflächen eine Schicht aus Kupferpaste und auf die andere der zu verbindenden Oberflächen ein Lotmittel oder eine 10 bis 500 µm dicke Zinn(legierungs)schicht appliziert und die Bauelemente 1 und 2 so anordnet, dass ihre zu verbindenden Oberflächen über die Schicht aus Kupferpaste und das Lotmittel oder über die Schicht aus Kupferpaste und die Zinn(legierungs)schicht in Kontakt stehen, oder
(b4) auf eine der zu verbindenden Oberflächen eine Schicht aus Kupferpaste appliziert und die Bauelemente 1 und 2 so anordnet, dass ihre zu verbindenden Oberflächen über die Schicht aus Kupferpaste in Kontakt stehen, und ein Lotmittel neben die oder auf einen von einem der Bauelemente 1 oder 2 nicht verdeckten Anteil der Schicht aus Kupferpaste appliziert, und
(c) die in Schritt (b1), (b2), (b3) oder (b4) geschaffene Anordnung verlötet,
wobei die Kupferpaste (i) 66 - 90 Gew.-% mindestens einer Art von Partikeln ausgewählt aus der aus Kupferpartikeln, kupferreichen Kupfer/Zink-Legierungspartikeln und kupferreichen Kupfer/Zinn-Legierungspartikeln bestehenden Gruppe, (ii) 0 - 20 Gew.-% mindestens einer Art von Lotpartikeln ausgewählt aus der aus Zinnpartikeln, zinnreichen Zinn/Kupfer-Legierungspartikeln, zinnreichen Zinn/Silber-Legierungspartikeln und zinnreichen Zinn/Kupfer/Silber-Legierungspartikeln bestehenden Gruppe und (iii) 10 - 20 Gew.-% Vehikel enthält, wobei die Partikel (i) eine mittlere Partikelgröße im Bereich von 20 bis 50 µm aufweisen und wobei die absoluten Partikelgrößen der Partikel (i) zumindest im Wesentlichen innerhalb des Bereichs von ≥ 4 µm bis ≤ 70 µm liegen.

2. Verfahren nach Anspruch 1, wobei die Bauelemente 1 und 2 elektronische Bauelemente sind.

3. Verfahren nach Anspruch 1 oder 2, wobei es sich bei den zu verbindenden Oberflächen der beiden Bauelemente 1 und 2 um Kontaktflächen handelt, deren Größe im Bereich von 1 bis 100000 mm², insbesondere 1 bis 12000 mm² liegen.

4. Verfahren nach einem der vorhergehenden Ansprüche, wobei die Kupferpaste und das Lotmittel bleifrei sind.

5. Verfahren nach einem der vorhergehenden Ansprüche, wobei es sich bei den Partikeln (i) um durch Schmelzverdüsung unter Luft- oder Inertgasatmosphäre hergestellte Partikel handelt.

6. Verfahren nach einem der vorhergehenden Ansprüche, wobei das Vehikel (iii) Verdicker und organisches Lösemittel umfasst.

7. Verfahren nach einem der vorhergehenden Ansprüche, wobei die Kupferpaste durch Siebdruck, Schablonendruck, Jet- oder Dispenstechnik in einer Schichtdicke von 20 - 200 µm appliziert und dann gegebenenfalls zunächst getrocknet wird.

8. Verfahren nach einem der vorhergehenden Ansprüche, wobei es sich bei dem Lotmittel um eine Lotpaste oder um ein oder mehrere Formteile aus Lotmetall handelt.

9. Verfahren nach Anspruch 7 oder 8, wobei die Applikation neben die Schicht aus gegebenenfalls getrockneter Kupferpaste gemäß Schritt (b4) so erfolgt, dass die Lotpaste oder das mindestens eine Lotmetallformteil die gegebenenfalls getrocknete Kupferpaste seitlich berührt oder einen geringen Abstand dazu hat.
